(19) Europäisches Patentamt
European Patent Office
Office européen des brevets

(11) **EP 4 145 487 A1**

(12) **EUROPEAN PATENT APPLICATION**
published in accordance with Art. 153(4) EPC

(43) Date of publication:
**08.03.2023 Bulletin 2023/10**

(51) International Patent Classification (IPC):
**H01J 37/20** (2006.01)     **H01J 37/09** (2006.01)
**H01F 7/20** (2006.01)

(21) Application number: **21813253.8**

(22) Date of filing: **21.04.2021**

(86) International application number:
**PCT/CN2021/088575**

(87) International publication number:
**WO 2021/238509 (02.12.2021 Gazette 2021/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.05.2020 CN 202010460837**

(71) Applicant: **Ningbo Institute of Materials Technology & Engineering, Chinese Academy of Sciences Ningbo, Zhejiang 315201 (CN)**

(72) Inventors:
• **XIA, Weixing**
  **Ningbo, Zhejiang 315201 (CN)**

• **BAI, Tian**
  **Ningbo, Zhejiang 315201 (CN)**
• **SUN, Xin**
  **Ningbo, Zhejiang 315201 (CN)**
• **QIN, Jiazhuan**
  **Ningbo, Zhejiang 315201 (CN)**
• **CHEN, Renjie**
  **Ningbo, Zhejiang 315201 (CN)**
• **YAN, Aru**
  **Ningbo, Zhejiang 315201 (CN)**
• **LI, Wei**
  **Ningbo, Zhejiang 315201 (CN)**

(74) Representative: **Petraz, Gilberto Luigi et al GLP S.r.l. Viale Europa Unita, 171 33100 Udine (IT)**

(54) **MAGNETIC FIELD GENERATION DEVICE, AND TRANSMISSION ELECTRON MICROSCOPE SAMPLE HOLDER CAPABLE OF APPLYING MAGNETIC FIELD**

(57) The present disclosure provides a transmission electron microscope sample holder capable of applying a magnetic field. The transmission electron microscope sample holder includes a holder body (1) and a holder head (2), wherein the holder head (2) is arranged at an end of the holder body (1), and the holder head (2) is provided with a magnetic field generation device; and the magnetic field generation device (4) is provided with magnetic field generation end surface, the thickness of the magnetic field generation end surface is in a range of 100 nanometers to 280 micrometers, and the thickness is of a size that is parallel to a direction of an electron beam in a transmission electron microscope.

FIG. 2

EP 4 145 487 A1

## Description

## CROSS-REFERENCE TO RELATED APPLICATION

This application claims all benefits accruing from China Patent Application No. 202010460837.X, filed on May 27, 2020, titled "MAGNETIC FIELD GENERATION DEVICE, AND TRANSMISSION ELECTRON MICROSCOPE SAMPLE HOLDER CAPABLE OF APPLYING MAGNETIC FIELD" in the China National Intellectual Property Administration, and the content of which is hereby incorporated by reference.

## TECHNICAL FIELD

The present disclosure generally relates to the technical field of transmission electron microscope accessories, and in particular, to a transmission electron microscope sample holder capable of applying magnetic field.

## BACKGROUND

Transmission electron microscopy (TEM) is a very important analytical and characterization method in the field of material science. With an application of spherical aberration correction technology, a resolution of TEM has been increased from nanometer-scale to picometer-scale, which can be used to clearly observe a microstructure of a material at an atomic level. Due to the requirements in scientific research, in-situ observation technology of electron microscope has been gradually developed in recent years. A characteristic of the in-situ observation technology of electron microscope is that the changes in microstructure and micro-property of a specimen can be in-situ observed under influence of applied physical fields such as temperature, electric field, magnetic field, stress, light, etc. in real time. The in-situ observation technology is helpful to find novel phenomena and understand microscopic mechanisms of a macroscopic property of a material in the field of physics and material science. In recent years, many high-tech companies making in-situ TEM sample holders have been set up in the world. In-situ TEM sample holders having various functions such as controlling the specimen temperature, applying and adjusting an electric field, a magnetic field and a stress to the specimen, and introducing a laser, have been developed. These in-situ technologies have been used in physics and material research, fruitful research results have been achieved and at the same time many application problems in materials have been solved, enabling a flourishing development in in-situ electron microscopy technology.

Electromagnetic properties are important for a material and a device. An in-situ experiment with a magnetic field can be used to characterize changes in electrical transport characteristics, the magnetic phase transition, the magnetic domain reversal and domain wall displacement of magnetic materials. These enrich people's understanding of the electromagnetic property and the relationship between microstructure and macro-property, providing experimental evidences and theoretical supports for development of various electromagnetic functional devices. At present, many commercial in-situ sample holders with functions of temperature, electric field, stress and light have been manufactured, however, in-situ magnetic holder are not well developed and the field strength that can be applied by holder are low. Some reported researches on in-situ magnetic field holders are shown herein.

Inoue et al. of JEOL developed a magnetic specimen stage (Journal of Electron Microscopy 54(2005) 509) in 2005, which used a magnetic circuit composed of soft magnetic material and an energizing coil surrounding the circuit to generate a magnetic field at a gap. The specimen mounted is standard in TEM with a diameter of 3 mm. The thickness of the iron core at the gap (a size of the iron core parallel to a direction of an electron beam) is about 2 mm, and the maximum strength of magnetic field that can be applied is 500 Oe. At the same time, two coils integrated on the column of TEM are necessary to compensate the deflection of electron beam in order to obtain clear images. Uhlig et al. of University of Regensburg in Germany designed a method of an in-situ magnetization experiment (Ultramicroscopy, 94(2003)193), where the magnetic field is generated by two electromagnets perpendicular to each other in a sample plane. The field strengths along two directions are controlled by a computer program, enabling the vector sum of the two fields along any direction in the sample plane. The holder can be used in Philips CM30 Twin/LTEM and a clear image can be obtained when the field strength is 63 Oe. M. Arita et al. of Hokkaido University in Japan designed a double-layer electromagnet system (Materials Transactions 55 (2014) 403), each layer of which is a kind of four-pole electromagnet with ring-shaped yoke. The magnetic core is made of permalloy to increase the magnetic field and reduce the stray field. The sample stage can generate a magnetic field in any direction in sample plane with a maximum value of 200 Oe. G. Yi et al. of the University of Glasgow in UK used two straight current-carrying wires to generate a parallel magnetic field to act on a sample (Ultramicroscopy 99 (2004) 65). Diameters of the two gold wires are 100 micrometers and a distance between them is 100 micrometers. When electric currents with the same value and direction are passed through the two gold wires, an in-plane magnetic field can be generated and applied to the sample. The magnetic field generated under the energized wires could automatically compensate the deflected electron beam, so that it would not affect imaging condition. A generated maximum field strength by a pulse current is about 300 Oe. Shindo of Tohoku University in Japan proposed a specimen holder to generate field with a permanent magnet needle (US patent US2005/0274889 A1). The maximum field strength of HummingBird's (U.S.) products can reach 900 Oe (www.hummingbirdscientific.com). Haihua Liu et al. of Institute of Physics of Chinese Academy of Sciences designed and manufactured an in-situ single-tilt sample holder (Journal of Chinese Electron Microscopy Society 30 (2011) 97). Xin'an Yang et al. added a "U"-shaped magnetic coil to the tip of the holder and improved the specimen cup (Journal of Chinese Electron Microscopy Society 32 (2013) 416), and further designed and manufactured a double-tilt holder. Test results show that the holder can generate a continuous field with strength of 100 Oe and an instantaneous field with strength of 140 Oe, and the "U"-shaped magnetic element can limit the beam shift and avoid the image distortion.

In summary, although many kinds of in-situ magnetic field sample holders have been developed by researchers worldwide, the reported maximum value of applied field does not exceed 0.1 T (1000 Oe) when the holder are used in a general TEM with 200 kV or 300 kV accelerating voltage. The reasons are analyzed herein.

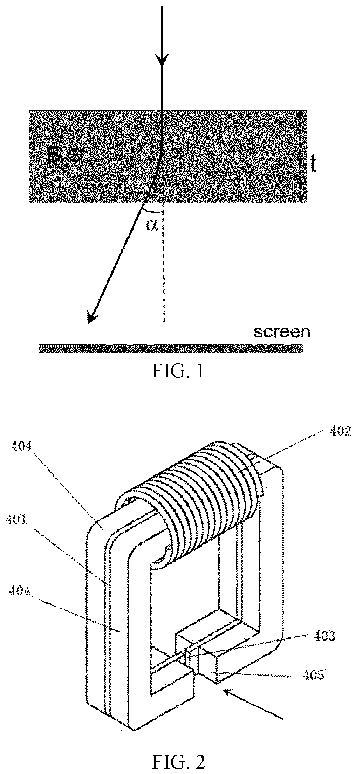

The design of an in-situ magnetic TEM holder needs to consider two factors. One aspect is to generate a magnetic field as large as possible, which is relatively simply carried out. A large magnetic field can be generated by using a soft magnetic material core with a high saturation magnetic flux density, a large excitation current of a coil and an appropriate gap width in the magnetic circuit. For reference, callout L2 in FIG.1 of US8158940B2 is a gap width. To increase the field strength, decreasing the gap width or increasing the end areas of the two poles facing the gap or both two are mostly effective methods. Another aspect is to make the defection of electron beam as small as possible. The generated magnetic field would deflect the electron beam by Lorentz force at the same time of the field acting on the sample, if the electron beam is deflected too much, it would affect or even fail to image. Referring to FIG. 1, the electron beam travelling vertically downwards the region with magnetic field inward-facing and perpendicular to the paper surface is deflected to the left due to the Lorentz force. A deflection angle $\alpha$ can be calculated by the following formula:

$$\alpha = \frac{4\pi t}{c}\left(\frac{e}{2Um}\right)^{\frac{1}{2}} B \quad (1) .$$

In the formula, $e, c, U, m, t$ and $B$ represent the electronic charge, the speed of light, the accelerating voltage of TEM, the electron mass, the range of the magnetic field and the field strength, respectively. It can be known that when the acceleration voltage is determined, the deflection angle of the electron beam is proportional to the product of the field strength and the application range of the magnetic field (denoted as $Bt$). If $Bt$ is too great, the deflection angle would be too great and the electron beam would deviate from the optic axis and hence the phosphor screen to result in incorrect sample image.

Most current in-situ magnetic field sample stages are designed for observing a standard TEM sample with a diameter of 3 mm, that means the width of the gap between the magnetic poles is 3 mm, which is a very large distance for a magnetic field generator of the TEM holder. Therefore, in order to generate a magnetic field with a certain strength, areas of the magnetic poles at the gap need to be enlarged, and the thickness of the magnetic pole along the direction of the electron beam is increased correspondingly, that is, t in formula (1) is large, usually in the millimeter scale. In this way, the value of $Bt$ is relatively large even when $B$ is small (<0.1T). For example, in a 200kV-TEM, when B is 0.015 T (t=2 mm) the deflection angle $\alpha$ is 19.1 mrads (1.09 degs), under this condition the sample can be barely enough imaged. If the magnetic field is further increased to 0.05T, then the deflection angle $\alpha$ becomes 63.5 $mrads$ (3.64 $degs$), at this time the electron beam deflection is too great to image. In order to solve this problem, many of the conventional arts design two or more deflection coils to compensate the ray path as field increases (such as callouts 9 and 10 in FIG.1 of US8158940B2, and callouts 070 and 090 in FIG.1 of US2004/0061066A1). Even the compensation deflection coils are used, the maximum field that can be applied in a conventional 200kV- or 300kV-TEM does not exceed 0.1 T, which greatly limits the application of the in-situ magnetic field holder in research work of magnetic materials.

According to the analysis above, to increase the magnetic field $B$ without generating large electron beam deflection, a feasible method is to reduce t so that the value of $Bt$ remains unchanged or even becomes less. Akira Sugawara et al. reduced the thickness of the magnetic poles to 300 micrometers and the gap width to 180 micrometers (Table 1 in Ultramicroscopy 197 (2019) 105, and US9070532B2), so that the maximum value of the magnetic field was increased to 0.5 T when the ray path was compensated with deflection coils. Although this is a relatively great improvement, the 0.5 T field-strength was measured in a TEM with accelerating voltage of 1MV. From formula (1), it can be known that when the accelerating voltage U becomes greater, the deflection angle will become less. Therefore, whether their holder at such a large field can be used in a general 200kV- or 300kV-TEM remains to be verified by experiments.

## SUMMARY

The present disclosure provides a magnetic field generation device which is capable of generating a magnetic field of more than 0.1 T and reaching a maximum value of 1.5 T.

The present disclosure provides the magnetic field generation device with the following structure. The magnetic field generation device is provided with a magnetic field generation end surface, a thickness of the magnetic field generation end surface is in a range of 100 nanometers to 280 micrometers, and the thickness of the magnetic field generation end surface is a size of the magnetic field generation end surface that is parallel to the direction of the electron beam in a transmission electron microscope.

In this way, compared with the related art, the magnetic field generation device in the present disclosure includes the following advantages.

Since the thickness of the magnetic field generation end surface of the magnetic field generation device of the present disclosure is in a range of 100 nanometers to 280 micrometers, the magnetic field generation device with this structure is capable of generating a stable and uniform magnetic field with the strength from 0 T to 1.5 T.

In some embodiments, the magnetic field generation device is provided with a gap, and both end surfaces of the magnetic field generation device at both sides of the gap are defined as the two magnetic field generation end surfaces. A width of the gap is in a range from 50 nanometers to 50 micrometers, and the width of the gap is a size of the gap that is perpendicular to the direction of the electron beam in the transmission electron microscope. In this way, the magnetic field generation device is more effective in generating magnetic fields.

In some embodiments, the thickness of the magnetic field generation end surface is 20 micrometers, and the width of the gap is 3 micrometers. In this way, the magnetic field generation device is more effective in generating magnetic fields.

In some embodiments, the magnetic field generation device includes a soft magnetic material core and a coil, the coil is wound on the soft magnetic material core, and the gap is located on the soft magnetic material core. In this way, the magnetic field generation device has a more stable structure.

In some embodiments, the soft magnetic material core is in a shape of "□", the gap is located at one side of the soft magnetic material core, and the coil is wound on the other sides of the soft magnetic material core. In this way, the structure of the magnetic field generation device is more rational.

In some embodiments, both upper and lower sides of the soft magnetic material core are provided with non-magnetic support sheets which are also in the shape of "□". The non-magnetic support sheets are provided with a slit at the position corresponding to the gap. A width of the slit is larger than the width of the gap. Two ends of the soft magnetic material core are exposed outside two ends of the non-magnetic support sheets, respectively. The coil is wound outside the non-magnetic support sheets on both upper and lower sides of the soft magnetic material core. In this way, the magnetic field generation device is easy to be machined and assembled.

In some embodiments, two end surfaces of two ends of the soft magnetic material core are able to protrude to form two protrusions, respectively. The gap is located between the two protrusions. In this way, the soft magnetic material core is easy to be machined.

In some embodiments, two soft magnetic material cores are symmetrically provided, the two soft magnetic material cores are both wound with coils, and the gap is defined between end surfaces of ends of the two soft magnetic material cores. In this way, the magnetic field generation device has a simple structure, and the magnetic fields generated are more stable.

In some embodiments, the magnetic field generation device includes two superconductor coils, and the gap is defined between ends of the two superconductor coils. In this way, the magnetic field generation device has a simple structure, and the magnetic fields generated are more stable.

In some embodiments, the magnetic field generation device includes a soft magnetic material core which is wound with a coil, and end surfaces of the soft magnetic material core are the magnetic field generation end surface. In this way, the magnetic field generation device has a simple structure and is easy to be assembled.

In some embodiments, the magnetic field generation device includes a superconductor coil, and side surfaces of the ends of the superconductor coil are the magnetic field generation end surfaces. In this way, the magnetic field generation device has a simple structure and is easy to be assembled.

The present disclosure further provides a transmission electron microscope sample holder capable of applying a magnetic field, which is capable of generating a magnetic field having a maximum value of 1.5 T, and the magnetic field can be applied to an electron microscope sample while allowing high quality imaging of the sample.

The present disclosure provides the transmission electron microscope sample holder capable of applying the magnetic field with the following structure. The transmission electron microscope sample holder includes a holder body and a holder head, the holder head is arranged at an end of the holder body, and the holder head is provided with the magnetic field generation device having the above structure.

In this way, compared with the related art, the transmission electron microscope sample holder capable of applying the magnetic field in the present disclosure has the following advantages.

Since the thickness of the magnetic field generation end surface of the transmission electron microscope sample holder capable of applying the magnetic field in the present disclosure is in a range of 100 nanometers to 280 micrometers, the magnetic field generation device with this structure is capable of generating a stable and uniform magnetic field with the strength in a range of 0 to 1.5 T and applying the magnetic field to the electron microscope sample while allowing high quality imaging of the sample.

In some embodiments, a groove is located at the holder head, the magnetic field generation device is press-fitted in the groove with a pressing plate, and the gap is communicated with the outside. In this way, the magnetic field generation device is easy to be assembled.

In some embodiments, the holder head includes a supporting frame and a connecting portion. An end of the supporting frame is connected with the connecting portion, and the groove is located at another end of the supporting frame. An opening is located at a side of the groove close to the connecting portion. The gap is exposed outside the opening. In this way, the gap is exposed outside the opening, and it is easy for the sample to be delivered into the gap.

In some embodiments, a sample loading component is provided in the holder body, the sample loading component is capable of moving along three-dimensional directions. A needle is fixed on an end of the sample loading component, and a tip of the needle is capable of extending into the gap. In this way, the sample loading component can move along a length direction of the holder body to drive the sample on the tip of the sample loading component to enter or leave the gap, thus it is easy to load the sample and deliver the sample into the gap.

In some embodiments, the sample loading component includes a needle tube, a piezoelectric ceramic tube, and a needle, an end of the needle tube is connected with an end of the piezoelectric ceramic tube, another end of the piezoelectric ceramic tube is connected with an end of the needle, and another end of the needle is configured to fix an electron microscope sample. In this way, the piezoelectric ceramic tube can deform when energized, allowing the position of the sample on the needle to be adjusted in high spatial accuracy, and improving accuracy in detection of the sample.

In some embodiments, another end of the holder body is provided with a handle, a three-dimensional fine-tuning sliding table is provided in the handle, and another end of the needle tube is connected with the three-dimensional fine-tuning sliding table, an outer wall of a middle part of the needle tube is provided with a sealing ring, and the sealing ring is capable of sliding inside an inner wall of the holder body. In this way, a wide range of adjustment of the position of the sample on the needle of the sample loading component can be carried out by the three-dimensional fine-tuning sliding table, facilitating rapid sample positioning and detection.

**BRIEF DESCRIPTION OF THE DRAWINGS**

FIG. 1 is a schematic diagram of a deflection of an electron beam by a Lorentz force.

FIG. 2 is a structural schematic diagram of a magnetic field generation device in a first embodiment of the present disclosure.

FIG. 3 is a structural schematic diagram of a magnetic field generation device in a second embodiment of the present disclosure.

FIG. 4 is a structural schematic diagram of a magnetic field generation device in a third embodiment of the present disclosure.

FIG. 5 is a structural schematic diagram of a magnetic field generation device in a fourth embodiment of the present disclosure.

FIG. 6 is a structural schematic diagram of a magnetic field generation device in a fifth embodiment of the present disclosure.

FIG. 7 is a structural schematic diagram of a transmission electron microscope sample holder capable of applying a magnetic field in a seventh embodiment of the present disclosure.

FIG. 8 is a sectional schematic diagram of the transmission electron microscope sample holder capable of applying the magnetic field in the seventh embodiment of the present disclosure.

FIG. 9 is an exploded schematic diagram of a holder head of the transmission electron microscope sample holder capable of applying the magnetic field in the seventh embodiment of the present disclosure.

FIG. 10 is a structural schematic diagram of the holder head of the transmission electron microscope sample holder capable of applying the magnetic field in the seventh embodiment of the present disclosure.

FIG. 11 is a structural schematic diagram showing the working principle of the transmission electron microscope sample holder capable of applying the magnetic field in the seventh embodiment of the present disclosure.

FIG. 12 is an overall diagram of a finite element simulation of the magnetic field generation device in the first embodiment of the present disclosure.

FIG. 13 is a distribution of the magnetic field at the gap of the magnetic field generation device in the first embodiment of the present disclosure.

FIG. 14 is a relationship between the magnetic strength and an electric current at the gap of the magnetic field generation device in the first embodiment of the present disclosure.

FIG. 15 shows results of a magnetization process of a hot pressed NdFeB sample with a coercivity of 2.3 T observed by the present disclosure.

In the figures, 1 represents a holder body, 2 represents a holder head, 201 represents a supporting frame, 202 represents a connecting portion, 203 represents a mounting portion, 204 represents a supporting foot, 205 represents a groove, 3 represents a handle, 301 represents an electrical interface, 4 represents a magnetic field generation device, 401 represents a soft magnetic material core, 402 represents a coil, 403 represents a gap, 404 represents an oxygen-free copper sheet, 405 represents a slit, 5 represents a pressing plate, 6 represents a sample loading component, 601 represents a needle tube, 602 represents a needle, 603 represents a sealing ring, 604 represents a piezoelectric ceramic tube, 7 represents a three-dimensional fine-tuning sliding table.

## DETAILED DESCRIPTION OF THE EMBODIMENTS

Aspects of the present disclosure will be described more detailly with reference to the drawings of the present disclosure to understand the present disclosure better. Obviously, the detailed descriptions are merely descriptions of exemplary embodiments of the present disclosure and are not intended to limit the scope of the present disclosure in any way. Throughout the specification, the same accompanying symbols refer to the same elements.

In the figures, a thickness, a size and a shape of an object have been slightly exaggerated for ease of illustration. The figures are only examples and not strictly to scale.

A first embodiment

Referring to FIG. 2, the present disclosure provides a magnetic field generation device. The magnetic field generation device 4 can include a soft magnetic material core 401, a coil 402, a gap 403 and a non-magnetic support sheet 404. A direction of an arrow is the direction of the electron beam of a transmission electron microscope. The non-magnetic support sheet can include two oxygen-free copper sheets. The soft magnetic material core 401 can be in a shape of "▢" (a hollow square), and the two oxygen-free copper sheets 404 can be in a shape of "▢". The two oxygen-free copper sheets 404 can be affixed to both the upper and lower sides of the soft magnetic material core 401, respectively. The gap 403 can be located at one side of the soft magnetic material core 401. The coil 402 can be wound on one side of the soft magnetic material core 401 opposite to the gap 403, and the coil 402 can be wound outside the two oxygen-free copper sheets 404 on both the upper and lower sides of the soft magnetic material core 401. Each of the two oxygen-free copper sheets 404 is provided with a slit 405 at a position corresponding to the gap 403. A width of the slit 405 can be larger than a width of the gap. Two ends of the soft magnetic material core 401 can be exposed outside two ends of the two oxygen-free copper sheets 404, respectively. End surfaces of the soft magnetic material core 401 facing the gap 403 can be magnetic field generation end surface. A thickness of the magnetic field generation end surface can be in a range of 100 nanometers to 280 micrometers. A width of the gap 403 can be in a range of 50 nanometers to 50 micrometers. In the present embodiment, the soft magnetic material core 401 can have a rectangular cross-section. In the present embodiment, the thickness of the magnetic field generation end surface of the soft magnetic material core 401 facing gap 403 is 20 micrometers, and the width of the gap 403 is 3 micrometers. The magnetic field generation device 4 with the above structure can generate a magnetic field with a maximum value of 1.5 T.

A second embodiment

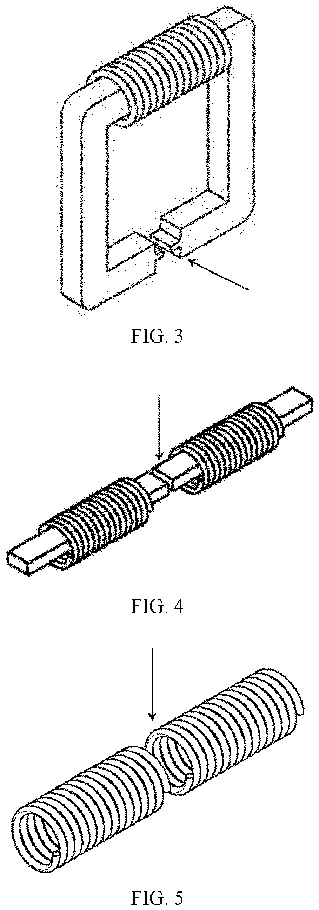

Referring to FIG. 3, a magnetic field generation device in the present embodiment can include a soft magnetic material core, a coil, and a gap. A direction of an arrow is the direction of the electron beam of a transmission electron microscope. The soft magnetic material core can be in a shape of "▢". The gap is located at a side of the soft magnetic material core, and the coil is wound on a side of the soft magnetic material core opposite to the gap. Two end surfaces of two ends of the soft magnetic material core are able to protrude to form two protrusions, respectively, and the gap is located between the two protrusions. The two protrusions can have a rectangular-shaped cross-section. The end surfaces of the soft magnetic material core facing the gap are magnetic field generation end surfaces. A thickness of the magnetic field generation end surface can be in a range of 100 nanometers to 280 micrometers. A width of the gap can be in a range of 50 nanometers to 50 micrometers. In the present embodiment, a thickness of the end surfaces of the soft magnetic material core facing the gap is 20 micrometers, and the width of the gap is 3 micrometers.

A third embodiment

Referring to FIG. 4, a magnetic field generation device in the present embodiment can include soft magnetic material cores, coils, and a gap. A direction of an arrow is the direction of the electron beam of a transmission electron microscope. Two soft magnetic material cores are provided. The two soft magnetic material cores can be both wound with the coil. The two soft magnetic material cores can be symmetrically arranged. The two soft magnetic material cores can be both in a shape of column. The end surfaces of the two soft magnetic material cores facing the gap can be magnetic field generation end surface. In some cases, two end surfaces of two ends of the soft magnetic material cores are able to protrude to form two protrusions, respectively, and the two ends of the two soft magnetic material cores are opposite to each other. The gap is located between the two protrusions. The two protrusions can have a rectangle-shaped cross-section, or a circular-shaped cross-section. A thickness of the magnetic field generation end surface can be in a range of 100 nanometers to 280 micrometers. A width of the gap can be in a range of 50 nanometers to 50 micrometers. In the present embodiment, a thickness of the end surfaces of the two soft magnetic material cores facing the gap is 20 micrometers, and the width of the gap is 3 micrometers.

A fourth embodiment

Referring to FIG. 5, a magnetic field generation device in the present embodiment can include two superconductor coils arranged symmetrically to each other. A direction of an arrow is the direction of the electron beam of a transmission electron microscope. A gap is defined between ends of the two superconductor coils. End surfaces of the two superconductor coils near the gap can be magnetic field generation end surface. A thickness of the magnetic field generation end surface (i.e., a diameter of the two superconductor coils) can be in a range of 100 nanometers to 280 micrometers. A width of the gap can be in a range of 50 nanometers to 50 micrometers. In the present embodiment, the thickness of the magnetic field generation end surface is 20 micrometers, and the width of the gap is 3 micrometers.

A fifth embodiment

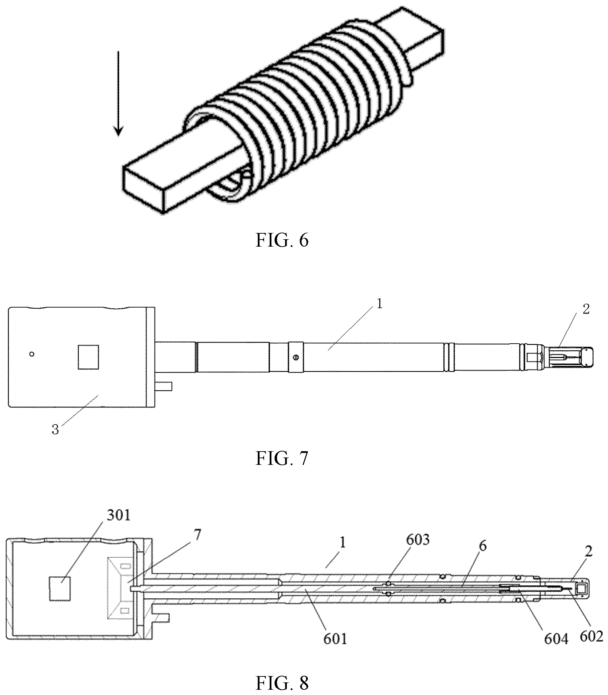

Referring to FIG. 6, a magnetic field generation device in the present embodiment can include a soft magnetic material core. The soft magnetic material core can be wound with a coil. A direction of an arrow is the direction of the electron beam of a transmission electron microscope. One end surface of the soft magnetic material core is the magnetic field generation end surface. A thickness of the magnetic field generation end surface can be in a range of 100 nanometers to 280 micrometers. In the present embodiment, the thickness of the magnetic field generation end surface is 20 micrometers.

A sixth embodiment

A magnetic field generation device in the present embodiment can include a superconductor coil. Both end surfaces of the superconductor coil can be magnetic field generation end surfaces. A thickness of the magnetic field generation end surface (i.e., a diameter of the superconductor coil) can be in a range of 100 nanometers to 280 micrometers. In the present embodiment, the thickness of the magnetic field generation end surface is 20 micrometers.

A seventh embodiment

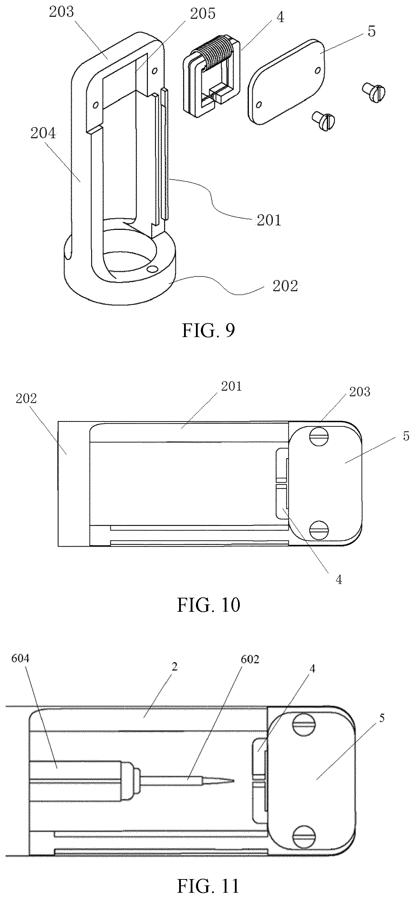

Referring to FIG. 7 to FIG. 11, a transmission electron microscope sample holder capable of applying a magnetic field in the present embodiment can include a holder body 1, a holder head 2, a handle 3, and a magnetic field generation device 4. The holder head 2 and the handle 3 are arranged at both ends of the holder body 1, respectively. Both the handle 3 and the holder body 1 have hollow constructions. The magnetic field generation device can be any one of the first embodiment to the sixth embodiment.

The holder head 2 can include a supporting frame 201 and a connecting portion 202. The supporting frame 201 can include a mounting portion 203 and two supporting feet 204. Ends of the two supporting feet 204 can be connected to two ends of a side of the mounting portion 203, respectively. The connecting portion 202 can be in a shape of ring, and other ends of the two supporting feet 204 can be connected to both sides of the connecting portion 202, respectively. A groove 205 can be located at a side of the mounting portion of the supporting frame 201. A first opening can be located at a side of the groove 205 close to the mounting portion 203, and a second opening can be located at a side of the groove 205 close to the connecting portion 202. Threaded holes can be located at the side of groove 205 close to the mounting portion 203.

The magnetic field generation device 4 can be mounted in the groove 205 of the supporting frame 201 via the first opening. A pressing plate 5 can be pressed on a side of the magnetic field generation device 4. The pressing plate 5 can be connected to the mounting portion 203 by means of screwing, i.e., the screws can be locked tightly in the threaded holes. The magnetic field generation device 4 can be press-fitted in the groove 205 by the pressing plate 5. A side of the magnetic field generation device 4 where the gap 403 is located can be exposed in the air outside the second opening.

The holder body 1 can be in a hollow tubular structure with openings at both ends. The connecting portion 202 of the holder head 2 can be fixed at an end of the holder body 1 by means of screwing. A middle part of the connecting portion 202 can be communicated with an inner chamber of the rod body 1. The handle 3 can be mounted on another end of the holder body 1, and an inner chamber of the handle 3 can be communicated with the inner chamber of the rod body 1. A sample loading component 6 can be provided in the holder body 1 and the sample loading component 6 can move along a length direction of the holder body 1. The sample loading component 6 can include a needle tube 601 and a needle 602, and the needle 602 is configured to fix an electron microscope sample. The needle tube 601 can be mounted in the holder body 1, an outer wall of a middle part of the needle tube 601 is provided with a sealing ring 603, and the sealing ring 603 is capable of sliding inside an inner wall of the holder body 1. The needle tube 601 is capable of moving transversely with respect to the sealing ring 603, i.e., the needle tube 601 can move transversely with the sealing ring 603 as a pivot point. An end of the needle tube 601 near holder head 2 is connected to an end of a piezoelectric ceramic tube 604 via a piezoelectric ceramic connector. Another end of the piezoelectric ceramic tube 604 can be connected to the needle 602. The handle 3 is provided with an electrical interface 301 which can be a vacuum electrical interface. The electrical interface 301 is connected to the piezoelectric ceramic tube 604 via conductive wires. The electrical interface 301 is connected to an external controller, and the external controller is configured to control a deformation of the piezoelectric ceramic tube 604. A three-dimensional fine-tuning sliding table 7 is provided in the handle 3 and can move in three-dimensional directions. An end of the needle tube 601 away from the holder head 2 is connected to the three-dimensional fine-tuning sliding table 7. The three-dimensional fine-tuning sliding table 7 can drive the needle tube 601 and thus the needle 602 moves.

A working principle of the transmission electron microscope sample holder capable of applying a magnetic field in the present disclosure is shown herein. Firstly, the electron microscope sample is fixed on an end of the needle 602, then the three-dimensional fine-tuning sliding table 7 is adjusted to bring the sample as close as possible to the gap 403, then the piezoelectric ceramic tube 604 is energized to make the piezoelectric ceramic tube 604 deform, so as to drive the sample on the end of the needle 602 to a proper position in the gap 403, and then the magnetic field generation device 4 is activated to apply magnetic field to the sample.

The magnetic field generation device 4 can be used separately. An experiment can be performed by welding two sides of the transmission electron microscope sample to magnetic field generation end surfaces of the magnetic field generation device, respectively.

Calculated values of the magnetic field of the magnetic field generation device of the first embodiment in the present disclosure and experimentally verified results are shown as follows.

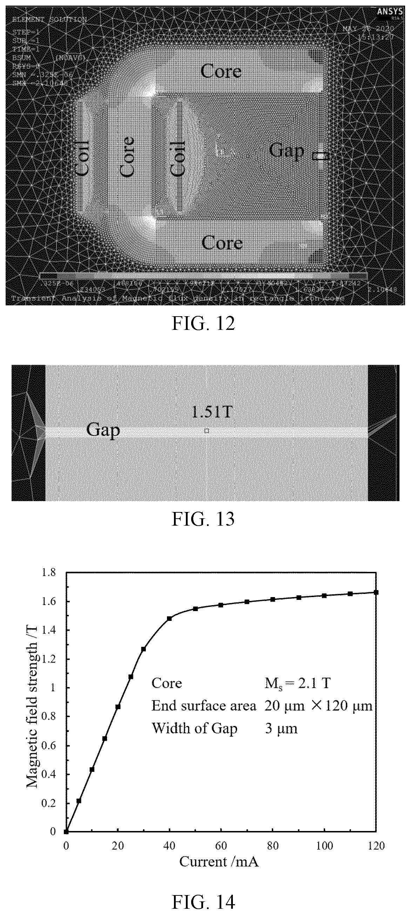

In the first embodiment of the present disclosure, the magnetic field generation device has a reduced iron core thickness at the gap compared with the related arts, thus the gap needs to be narrower to generate a strong magnetic field. A magnetic field strength in the gap with a width of 3 micrometers cannot be measured directly, but can be calculated by a finite element method using a software ANSYS as shown in FIG. 12. FIG. 13 is the magnified images of the area indicated by black box in FIG. 12, it can be seen that a uniform strong magnetic field is generated from an edge to the interior of the gap. FIG. 14 shows the magnetic field strength at the gap as a function of the electric current of the coil. The parameters used are as follows, the saturation magnetic flux density of the soft magnetic material is 2.1T, a thickness of the core is 20 micrometers (a size of the core along the direction perpendicular to the electron beam is 120 micrometers), and the width of the gap is 3 micrometers. It can be concluded that the magnetic fields strength varies basically linearly with the current in a range from 0 to around 1.5 T.

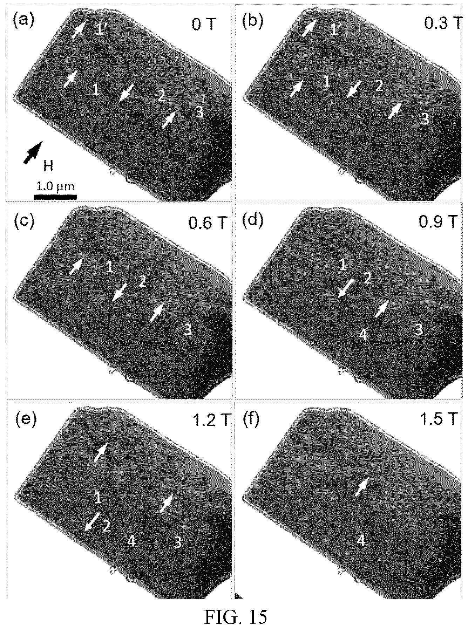

FIG. 15 shows an experimentally observed result of a sample by a Lorentz electron microscope. The sample is a hot-pressed NdFeB magnet with a coercivity of 2.3 T. An evolution process of the sample from a demagnetized state to a magnetized saturation state by gradually increasing magnetic field strength is observed at Fresnel over-focus mode. FIG. 15 (a) to FIG. 15 (f) are screenshots from a continuous video. Domain walls are indicated by white numbers on them and directions of magnetization within magnetic domains are indicated by white arrows. FIG. 15 (a) shows a thermally demagnetized state, and callouts 1, 1', 2, and 3 in FIG. 15 (a) indicate the domain walls, where the white or black contrast of the domain wall is formed by the relative directions of magnetization at two sides of the magnetic domain walls. It can be shown that in the thermally demagnetized state, the sample has three magnetic domains, the magnetization direction of the domain at the center is opposite to that of the domain on either side of the middle magnetic domain. A direction of the applied magnetic field H is shown by the black arrow in FIG. 15 (a). As shown in FIG. 15 (b), when the field is increased to 0.3 T, domain wall 2 moves to the upper left. At this point, domain wall 2 is not so clear due to the influence of the diffraction contrast of the lamellar crystal particles around it. As shown in FIG. 15 (c) when the magnetic field is further increased to 0.6T, domain wall 1' moves to lower-right and merges with domain wall 1, hereafter it is referred to as domain wall 1. As shown in FIG. 15(d) when the magnetic field is further increased to 0.9 T, the domain wall 2 continues to move to upper-left, forming an interrupted black line. As shown in FIG. 15 (e), when the field strength is 1.2 T, the upper parts of domain wall 1 and 2 merge, and only the lower part of the original center domain, the area between new domain wall 1 and 2, is left. As shown in FIG. 15 (f), when the magnetic field is 1.5 T, the domain between domain wall 1 and domain wall 2 disappears, while domain wall 3 moves right and disappears. The result of the movement of the domain walls is that the areas of the domain with magnetization direction the same as the external magnetic field become larger, while the area in the opposite direction become smaller, eventually the sample reaches saturation state. A small section of white domain wall indicated by 4 appears and keeps from FIG. 15 (d) to FIG. 15 (f), which is probably due to the strong domain wall pinning at this location. A hot-pressed NdFeB sample (AIP Advances 8 (2018) 015227) with a coercivity of 2.1 T has been observed by applying the magnetic field by the objective lens. Compared with the results in the related art, the result in FIG. 15 is sufficient to demonstrate that the sample holder is capable of applying a very strong magnetic field. Although the area of the magnetic field is too small to measure the field strength directly by a Hall sensor, based on the calculation of the finite element method described above and the experimental results shown in FIG. 15, it can be concluded that the magnetic field strength can reach 1.5 T.

According to formula (1), when $B$ is 1.5 T and $t$ is 20 micrometers, the deflection angle $\alpha$ of the electron

beam in a 200 kV-transmission electron microscope is equal to 19.1 $mrads$ (1.09$degs$). At a low magnification, as shown in FIG. 15, the distortion in image is little and it does not affect the observation of the magnetic domain. If the imaging quality needs to be further improved, the deflection coil fields for ray path compensation in other designs can be added.

**Claims**

1. A transmission electron microscope sample holder, which is capable of applying a magnetic field, **characterized by** comprising

    a holder body and a holder head, the holder head being arranged at an end of the holder body, wherein the holder head is provided with a magnetic field generation device, the magnetic field generation device is provided with a magnetic field generation end surface, a thickness of the magnetic field generation end surface is in a range of 100 nanometers to 280 micrometers, and the thickness of the magnetic field generation end surface is a size of the magnetic field generation end surface that is parallel to a direction of an electron beam in a transmission electron microscope.

2. The transmission electron microscope sample holder of claim 1, wherein the magnetic field generation device is provided with a gap, and both end surfaces of the magnetic field generation device at both sides of the gap are defined as the two magnetic field generation end surfaces;
    a width of the gap is in a range of 50 nanometers to 50 micrometers, and the width of the gap is a size of the gap that is perpendicular to the direction of the electron beam in the transmission electron microscope.

3. The transmission electron microscope sample holder of claim 2, wherein the thickness of the magnetic field generation end surface is 20 micrometers, and the width of the gap is 3 micrometers.

4. The transmission electron microscope sample holder of claim 2, wherein the magnetic field generation device comprises a soft magnetic material core and a coil, the coil is wound on the soft magnetic material core, and the gap is located on the soft magnetic material core.

5. The transmission electron microscope sample holder of claim 4, wherein the soft magnetic material core is in a shape of "▢", the gap is located at one side of the soft magnetic material core, and the coil is wound on the other sides of the soft magnetic material core.

6. The transmission electron microscope sample holder of claim 5, wherein both upper and lower sides of the soft magnetic material core are provided with non-magnetic support sheets which are also in the shape of "▢", the non-magnetic support sheets are provided with a slit at a position corresponding to the gap, a width of the slit is larger than the width of the gap, two ends of the soft magnetic material core are exposed outside two ends of the non-magnetic support sheets, respectively; and the coil is wound outside the non-magnetic support sheets on the upper and lower sides of the soft magnetic material core.

7. The transmission electron microscope sample holder of claim 5, wherein two end surfaces of two ends of the soft magnetic material core are able to protrude to form two protrusions, respectively, and the gap is located between the two protrusions.

8. The transmission electron microscope sample holder of claim 4, wherein two soft magnetic material cores are symmetrically provided, the two soft magnetic material cores are both wound with the coil, and the gap is defined between end surfaces of ends of the two soft magnetic material cores.

9. The transmission electron microscope sample holder of claim 2, wherein the magnetic field generation device comprises two superconductor coils, and the gap is defined between ends of the two superconductor coils.

10. The transmission electron microscope sample holder of claim 1, wherein the magnetic field generation device comprises a soft magnetic material core which is wound with a coil, and end surfaces of the soft magnetic material core are the magnetic field generation end surface.

11. The transmission electron microscope sample holder of claim 1, wherein the magnetic field generation device comprises a superconductor coil, and side surfaces of the ends of the superconductor coil are the magnetic field generation end surfaces.

12. The transmission electron microscope sample holder of claim 2, wherein a groove is located at the holder head, the magnetic field generation device is press-fitted in the groove with a pressing plate, and the gap is in communication with the outside.

13. The transmission electron microscope sample holder of claim 12, wherein the holder head comprises a supporting frame and a connecting portion, an end of the supporting frameis connected with the connecting portion, the groove is located at another end of the supporting frame; an opening is located at a side of the groove close to the connecting portion; and the gap is exposed outside the opening.

14. The transmission electron microscope sample holder of claim 13, wherein a sample loading component is provided in the holder body, the sample loading component is capable of moving along three-dimensional directions, a needle is fixed on an end of the sample loading component, and a tip of the needle is capable of extending into the gap.

15. The transmission electron microscope sample holder of claim 13, wherein the sample loading component comprises a needle tube, a piezoelectric ceramic tube, and a needle, an end of the needle tube is connected with an end of the piezoelectric ceramic tube, another end of the piezoelectric ceramic tube is connected with an end of the needle, and another end of the needle is configured to fix an electron microscope sample.

16. The transmission electron microscope sample holder of claim 15, wherein another end of the holder body is provided with a handle, a three-dimensional fine-tuning sliding table is provided in the handle, and another end of the needle tube is connected with the three-dimensional fine-tuning sliding table, an outer wall in the middle part of the needle tube is provided with a sealing ring, and the sealing ring is capable of sliding along an inner wall of the holder body.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

## INTERNATIONAL SEARCH REPORT

| International application No. |
| --- |
| **PCT/CN2021/088575** |

**A. CLASSIFICATION OF SUBJECT MATTER**

H01J 37/20(2006.01)i; H01J 37/09(2006.01)i; H01F 7/20(2006.01)i

According to International Patent Classification (IPC) or to both national classification and IPC

**B. FIELDS SEARCHED**

Minimum documentation searched (classification system followed by classification symbols)

H01J;H01F

Documentation searched other than minimum documentation to the extent that such documents are included in the fields searched

Electronic data base consulted during the international search (name of data base and, where practicable, search terms used)

CNABS; CNTXT; VEN; USTXT; EPTXT; WOTXT; CNKI: 透射电子显微镜, 透射电镜, 样品杆, 磁铁, 磁场, 气隙, transmission electron microscope, TEM, sample holder, magnet, magnetic field, air gap

**C. DOCUMENTS CONSIDERED TO BE RELEVANT**

| Category* | Citation of document, with indication, where appropriate, of the relevant passages | Relevant to claim No. |
| --- | --- | --- |
| PX | CN 112038039 A (NINGBO INSTITUTE OF MATERIALS TECHNOLOGY AND ENGINEERING, CHINESE ACADEMY OF SCIENCES) 04 December 2020 (2020-12-04) description, paragraphs 11-74, and figures 1-15 | 1-16 |
| X | JP H08264146 A (HITACHI LTD.) 11 October 1996 (1996-10-11) description, paragraphs 2-28, and figures 1-5 | 1-16 |
| X | EP 2797099 A2 (HITACHI LTD.) 29 October 2014 (2014-10-29) description, paragraphs 13-39, and figures 1-9 | 1-16 |
| A | CN 102820196 A (INSTITUTE OF PHYSICS CHINESE, ACADEMY OF SCIENCES) 12 December 2012 (2012-12-12) entire document | 1-16 |
| A | CN 104916516 A (LANZHOU UNIVERSITY) 16 September 2015 (2015-09-16) entire document | 1-16 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **18 July 2021** | **26 July 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/088575**

| Patent document cited in search report | | | Publication date (day/month/year) | Patent family member(s) | | | Publication date (day/month/year) |
|---|---|---|---|---|---|---|---|
| CN | 112038039 | A | 04 December 2020 | None | | | |
| JP | H08264146 | A | 11 October 1996 | None | | | |
| EP | 2797099 | A2 | 29 October 2014 | US | 9070532 | B2 | 30 June 2015 |
| | | | | EP | 2797099 | B1 | 27 September 2017 |
| | | | | US | 2014319371 | A1 | 30 October 2014 |
| | | | | JP | 2014216180 | A | 17 November 2014 |
| | | | | JP | 6061771 | B2 | 18 January 2017 |
| CN | 102820196 | A | 12 December 2012 | CN | 102820196 | B | 04 February 2015 |
| CN | 104916516 | A | 16 September 2015 | CN | 104916516 | B | 22 March 2017 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202010460837X
- US 20050274889 A1
- US 8158940 B2
- US 20040061066 A1
- US 9070532 B2

### Non-patent literature cited in the description

- *Journal of Electron Microscopy,* 2005, vol. 54, 509
- *Ultramicroscopy,* 2003, vol. 94, 193
- *Materials Transactions,* 2014, vol. 55, 403
- *Ultramicroscopy,* 2004, vol. 99, 65
- *Journal of Chinese Electron Microscopy Society,* 2011, vol. 30, 97
- **XIN'AN YANG et al.** U''-shaped magnetic coil to the tip of the holder and improved the specimen cup. *Journal of Chinese Electron Microscopy Society,* 2013, vol. 32, 416
- *Ultramicroscopy,* 2019, vol. 197, 105
- *Advances,* 2018, vol. 8, 015227